# EUROPEAN PATENT APPLICATION

(11) **EP 4 462 485 A1**
(43) Date of publication of application: **13.11.2024**
(21) Application number: 24172734.6
(22) Date of filing: 26.04.2024
(51) Int. Cl.: H01L 29/861, H01L 29/06, H01L 27/02, H01L 21/82, H01L 29/40

(54) **LATERAL DIODE FOR BACKSIDE POWER RAIL APPLICATION**

(30) Priority: 08.05.2023 US 202363464930 P; 17.04.2024 US 202418638650
(71) Applicant: MediaTek Inc., Hsin-Chu 300 (TW)
(72) Inventor: CHIU, Shih-Chuan, 30078 Hsinchu City (TW); HU, Chia-Hsin, 30078 Hsinchu City (TW); ZENG, Zheng, 30078 Hsinchu City (TW)
(74) Representative: Haseltine Lake Kempner LLP

(57) **Abstract**

The present invention provides a semiconductor structure, wherein the semiconductor structure includes an oxide definition region, a plurality of metal gate structures and a plurality of S/D contacts. The oxide definition region is disposed over a semiconductor substrate and surrounded by insulating regions. The plurality of metal gate structures are disposed on an N-well or a P-well manufactured on the semiconductor substrate. The plurality of S/D contacts are disposed on the N-well or the P-well manufactured on the semiconductor substrate. In addition, the plurality of metal gate structures, the plurality of S/D contacts and the at least one dummy gate structure are within the oxide definition region.

## Description

This application claims the benefit of U.S. Provisional Application No. 63/464,930, filed on May 8th, 2023. The content of the application is incorporated herein by reference.

### Background

A power delivery network is designed to provide power supply and reference voltage to the active devices on the die most efficiently. Traditionally, it is realized as a network of low-resistive metal wires fabricated through back-end-of-line (BEOL) processing on the front-side of the wafer. The power delivery network shares this space with the signal network.

When the semiconductor process technology keeps scaling, BEOL capacitance and IR drop becomes serious and degrade the chip performance. In order to solve these problems, a backside power delivery is developed to eliminate the need to share interconnect resources between signal and power lines on the front-side of the wafer. Instead, the power line is moved to the back of the wafer so only signals are carried by front-side interconnects.

However, for the wafer having backside power delivery design, a silicon substrate will be thinning by polish, and a conventional diode may have no suitable current path for current transport. In detail, the conventional diode may have a P+ epitaxy and a N+ epitaxy positioned on different oxide definitions, and a current path is formed from the P+ epitaxy, N-well or P-well to the N+ epitaxy. If the wafer is polished very thin, the N-well/P-well connections between different operation domains will be cut off, causing the current path of the diode to disappear.

### Summary

It is therefore an objective of the present invention to provide a diode design, which has one directional current path for the backside power delivery applications, to solve the above-mentioned problems.

According to one embodiment of the present invention, a semiconductor structure is disclosed. The semiconductor structure comprises an oxide definition region, a plurality of metal gate structures and a plurality of S/D contacts. The oxide definition region is disposed over a semiconductor substrate and surrounded by insulating regions. The plurality of metal gate structures are disposed on an N-well or a P-well manufactured on the semiconductor substrate. The plurality of S/D contacts are disposed on the N-well or the P-well manufactured on the semiconductor substrate. In addition, the plurality of metal gate structures, the plurality of S/D contacts and the at least one dummy gate structure are within the oxide definition region.

These and other objectives of the present invention will no doubt become obvious to those of ordinary skill in the art after reading the following detailed description of the preferred embodiment that is illustrated in the various figures and drawings.

### Brief Description of the Drawings

FIG. 1 shows a top view of a lateral diode according to one embodiment of the present invention.
FIG. 2 shows a cross-section view of the Y-cut according to one embodiment of the present invention.
FIG. 3 shows a cross-section view of the X-cut according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

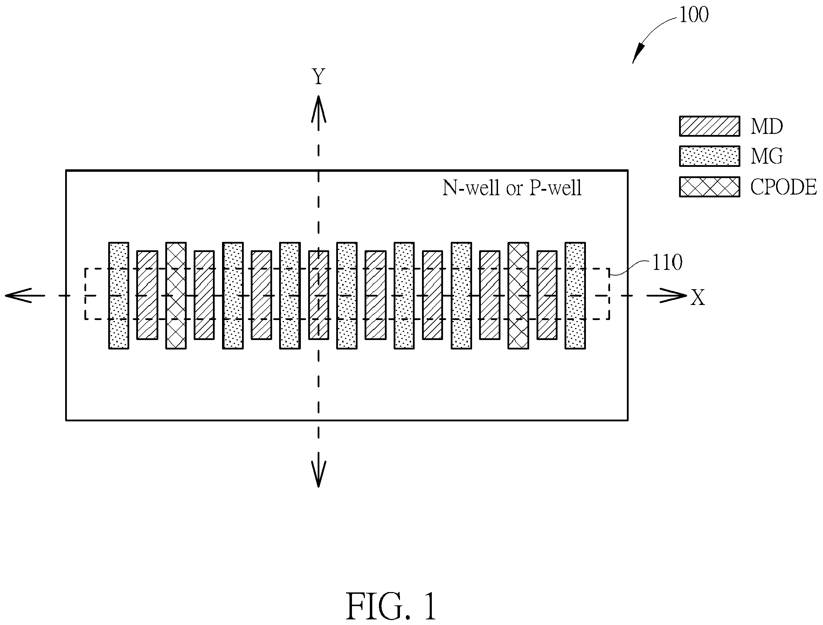

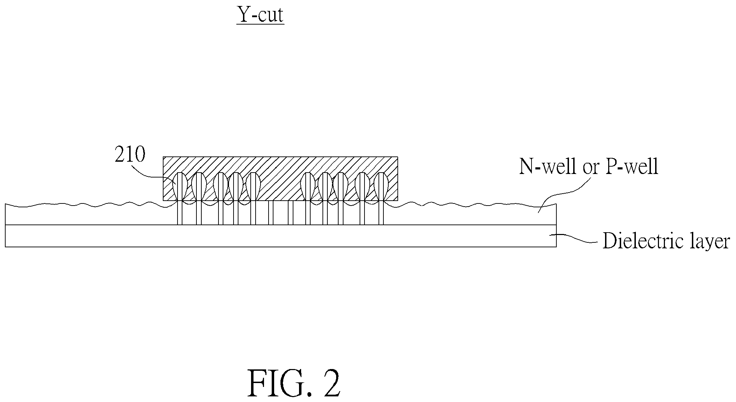

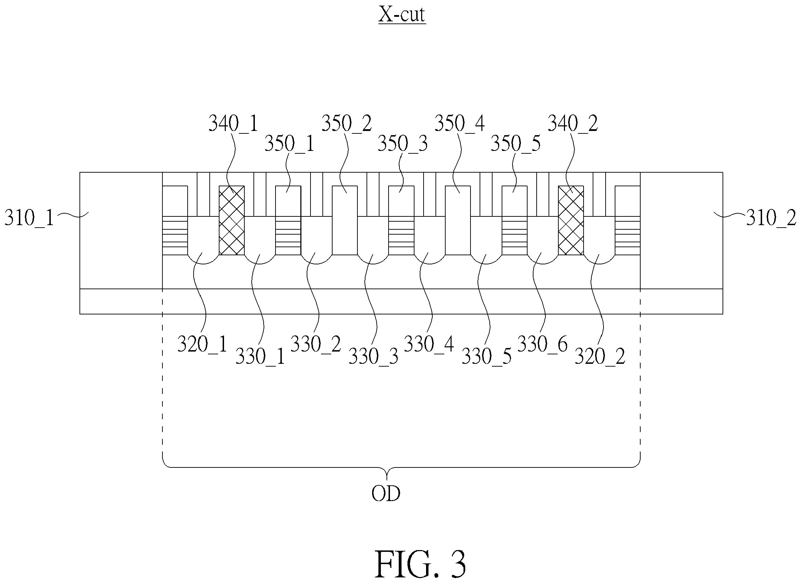

FIG. 1 - FIG. 3 are cross-section views of a lateral diode 100 according to one embodiment of the present invention, wherein FIG. 1 shows a top view (Z-direction) of the lateral diode 100, FIG. 2 shows a cross-section view of the Y-cut, and FIG. 3 shows a cross-section view of the X-cut.

In FIG. 1, a plurality source/drain (S/D) contacts (MD) and a plurality of metal gate structure (MG) are formed on a N-well or P-well manufactured on a semiconductor substrate such as silicon substrate, wherein the S/D contacts and metal gate structures are arranged in parallel and alternately. In this embodiment, the S/D contacts comprise source contacts and drain contacts, and the source contacts and the drain contacts are separated by a dummy gate structure, wherein the dummy gate structure is generally called an oxide definition edge (CPODE) pattern, and the dummy gate structure can serve as an insulating region manufactured by using silicon oxide, silicon nitride or silicon oxynitride. In addition, the source contacts and the drain contacts are all manufactured on the same oxide definition (OD) 110.

A continuous poly on the CPODE pattern is used to form a trench by removing a dummy structure and a portion of a substrate under the dummy structure. In at least one example, the term "oxide definition (OD)" is an active region for a semiconductor device such as a transistor or the lateral diode 100, i.e., the area where a source, a drain, and a channel under a gate of the transistor are formed. In some examples, the OD region is disposed over the semiconductor substrate and is between insulating regions, wherein the insulating regions are also called inactive regions or isolation regions. In some embodiments, the insulating regions are shallow trench isolation (STI), field oxide (FOX) areas, or other suitable electrically insulating structures.

The source/drain (S/D) contacts shown in FIG. 2 comprise metal layer and a plurality of epitaxial layer of N-doped or P-doped 210. In some embodiments, the P-type epitaxial material may include one or more epitaxial layers of silicon germanium (epi SiGe) doped with a P-type dopant such as boron, gallium, indium, and/or other P-type dopants. The N-type epitaxial material may include one or more epitaxial layers of silicon (epi Si) or silicon carbon (epi SiC) doped with an N-type dopant such as arsenic, phosphorus, and/or other n-type dopant.

In the cross-section view of the X-cut shown in FIG. 3, the lateral diode 100 is manufactured on the same OD surrounded by the insulating regions 310_1 and 310_2, wherein the insulating regions 310_1 and 310_2 may include silicon oxide, silicon nitride, silicon oxynitride, fluoride-doped silicate glass (FSG), a low-k dielectric material, other suitable materials, or combinations thereof. The lateral diode 100 comprises a plurality of first structures 320_1 and 320_2, a plurality of second structures 330_1 - 330_6, a plurality of dummy gate structures 340_1 and 340_2, and a plurality of metal gate structures 350_1 - 350_5 manufactured on the N-well or the P-well. The first structures 320_1 and 320_2 are included in source contacts or drain contacts, and the first structures 320_1 and 320_2 are positioned near the edge of the OD, that is the first structure 320_1 is positioned between the insulating region 310_1 and the dummy gate structure 340_1, and the first structure 320_2 is positioned between the insulating region 310_2 and the dummy gate structure 340_2. The second structures 330_1 - 330_6 are included in source contacts or drain contacts different from the first structures 320_1 and 320_2, and the second structures 330_1 - 330_6 are positioned between the dummy gate structures 340_1 and 340_2.

The first structures 320_1 and 320_2 and the second structures 330_1 - 330_6 are manufactured by epitaxial growth, and the first structures 320_1 and 320_2 and the second structures 330_1 - 330_6 are epitaxial layers with different type of doped materials. In one embodiment, the first structures 320_1 and 320_2 may be formed by the epitaxial layer of P-type epitaxial material, and the second structures 330_1 - 330_6 may be formed by the epitaxial layer of N-type epitaxial material. In another embodiment, the first structures 320_1 and 320_2 may be formed by the epitaxial layer of N-type epitaxial material, and the second structures 330_1 - 330_6 may be formed by the epitaxial layer of P-type epitaxial material.

In the embodiment shown in FIG. 1 - FIG. 3, by manufacturing the first structures 320_1 and 320_2 with the first-type doped material and the second structures 330_1 - 330_6 with the second-type doped material on the same OD, a current path can be formed to between the first structures 320_1 and 320_2 and the second structures 330_1 - 330_6 through the N-well or P-well below. Specifically, if the first structures 320_1 and 320_2 have the N-type epitaxial material and the second structures 330_1 - 330_6 have the P-type epitaxial material, a current is flowing from the second structures 330_1 - 330_6 to the first structures 320_1 and 320_2 through the N-well or P-well.

If the first structures 320_1 and 320_2 have the P-type epitaxial material and the second structures 330_1 - 330_6 have the N-type epitaxial material, a current is flowing from the first structures 320_1 and 320_2 to the second structures 330_1 - 330_6 through the N-well or P-well.

By using the embodiments mentioned above, if the wafer has backside power delivery design and a semiconductor substrate needs to be thinning by polish, the semiconductor device can still provide a current path in the X direction so that the lateral diode 100 can operate smoothly.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor structure, comprising:
an oxide definition, OD, region disposed over a semiconductor substrate and surrounded by insulating regions (310_1, 310_2);
a plurality of metal gate structures (350_1-350_5) disposed on an N-well or a P-well manufactured on the semiconductor substrate;
a plurality of source/drain, S/D, contacts disposed on the N-well or the P-well manufactured on the semiconductor substrate; and
wherein the plurality of metal gate structures (350_1-350_5), the plurality of S/D contacts and the at least one dummy gate structure (340_1, 340_2) are within the OD region.

2. The semiconductor structure of claim 1, wherein the plurality of S/D contacts comprise at least one source contact and at least one drain contact, and the semiconductor structure further comprises:
at least one first structure (320_1, 320_2) within one of the at least one source contact or the at least one drain contact, wherein the at least one first structure (320_1, 320_2) is formed by a first-type doped material; and
at least one second structure (330_1-330_6) within the other one of the at least one source contact or the at least one drain contact, wherein the at least one second structure (330_1-330_6) is formed by a second-type doped material.

3. The semiconductor structure of claim 2, wherein the first-type doped material is a P-type epitaxial material, and the second-type doped material is an N-type epitaxial material; or the first-type doped material is the N-type epitaxial material, and the second-type doped material is the P-type epitaxial material.

4. The semiconductor structure of claim 2, further comprising:
at least one dummy gate structure (340_1, 340_2) positioned between the at least one source contact or the at least one drain contact.

5. The semiconductor structure of claim 4, wherein the at least one dummy gate structure (340_1, 340_2) is an oxide definition edge, CPODE, pattern serving as another insulating region (310_1, 310_2).

6. The semiconductor structure of claim 4, wherein the at least one first structure (320_1, 320_2) is positioned between the at least one dummy gate structure (340_1, 340_2) and the insulating regions (310_1, 310_2).

7. The semiconductor structure of claim 4, wherein the first-type doped material is a P-type epitaxial material, the second-type doped material is an N-type epitaxial material, and a current path is from the at least one first structure (320_1, 320_2) to the at least one second structure through the N-well or the P-well.

8. The semiconductor structure of claim 4, wherein the first-type doped material is an N-type epitaxial material, the second-type doped material is a P-type epitaxial material, and a current path is from the at least one second structure to the at least one first structure (320_1, 320_2) through the N-well or the P-well.

9. The semiconductor structure of claim 1, wherein the semiconductor structure is a lateral diode (100).
